(19)

Europäisches
Patentamt
European
Patent Office
Office européen
des brevets

(11)   **EP 3 486 666 B1**

(12)   **EUROPEAN PATENT SPECIFICATION**

(45) Date of publication and mention
of the grant of the patent:
**28.07.2021 Bulletin 2021/30**

(51) Int Cl.:
***G01R 29/26*** *(2006.01)*        ***H04B 3/46*** *(2015.01)*

(21) Application number: **17201989.5**

(22) Date of filing: **16.11.2017**

(54) **MEASURING DEVICE AND MEASURING METHOD FOR NOISE-CORRECTED TRANSMITTER PERFORMANCE MEASUREMENT**

MESSVORRICHTUNG UND MESSVERFAHREN ZUR RAUSCHKORRIGIERTEN SENDERLEISTUNGSMESSUNG

DISPOSITIF DE MESURE ET PROCÉDÉ DE MESURE DES PERFORMANCES D'UN ÉMETTEUR À CORRECTION DE BRUIT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.05.2019 Bulletin 2019/21**

(73) Proprietor: **Rohde & Schwarz GmbH & Co. KG 81671 München (DE)**

(72) Inventor: **MENZEL, Edwin 81929 München (DE)**

(74) Representative: **Beder, Jens Mitscherlich PartmbB Patent- und Rechtsanwälte Sonnenstraße 33 80331 München (DE)**

(56) References cited:
JP-A- 2010 141 448     US-A1- 2007 225 927
US-A1- 2012 217 980     US-A1- 2015 138 995

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to measuring the performance of a transmitter. Especially, the invention comprises a measuring method and a measuring device.

For 5G equipment performance tests, very low noise levels of the equipment to be tested need to be measured. When measuring such low noise levels, the noise generated by a transmission channel from the device under test to the measuring device as well as the noise generated by the measuring device itself are significant factors. Eliminating these sources of noise by conventional means requires significant hardware effort.

Alternative methods for eliminating noise, like using a correlation of two signals are known for example from the document US 2007/0225927. Performing such a correlation though, also results in a high hardware effort.

The document US 2015/0138995 A1 shows a method, system and apparatus for phase noise cancellation. A pilot signal is generated outside of a signal bandwidth. The payload signal and the pilot signal are transmitted as a combined signal. This combined signal is received and again separated. By multiplying the pilot signal and the payload signal, phase noise is corrected.

The document US 2012/0217980 A1 shows a test device and test method for measuring a phase noise of a test signal. A test signal is digitized and then provided to at least two measuring paths having different delay values. The delayed measuring signals are then multiplied with each other and afterword low-pass filtered.

Moreover, the document JP 2010-141448 A shows a method and apparatus for signal detection, especially detecting the existence of a signal emitted from a source of radiation. A detection in a receiver is performed. Part of this detection is also a multiplication of the received signal with other signals.

Accordingly, the object of the present invention is to provide a measuring device and a measuring method, which allow for eliminating channel noise and measuring device noise while at the same time requiring only a low hardware complexity.

The object is solved by the features of claim 1 for the device and by the features of claim 15 for the method. The dependent claims contain further developments.

An exemplary embodiment of the invention is now further explained with respect to the drawings, in which

Fig. 1    shows an exemplary measuring device;

Fig. 2    shows a first embodiment of the inventive measuring device;

Fig. 3    shows a second embodiment of the inventive measuring device;

Fig. 4    shows a third embodiment of the inventive measuring device in a detail view showing only the measuring paths;

Fig. 5    shows a forth embodiment of the inventive measuring device;

Fig. 6    shows a fifth embodiment of the inventive measuring device;

Fig. 7    shows a sixth embodiment of the inventive measuring device, and

Fig. 8    shows an embodiment of the inventive measuring method in a flow diagram.

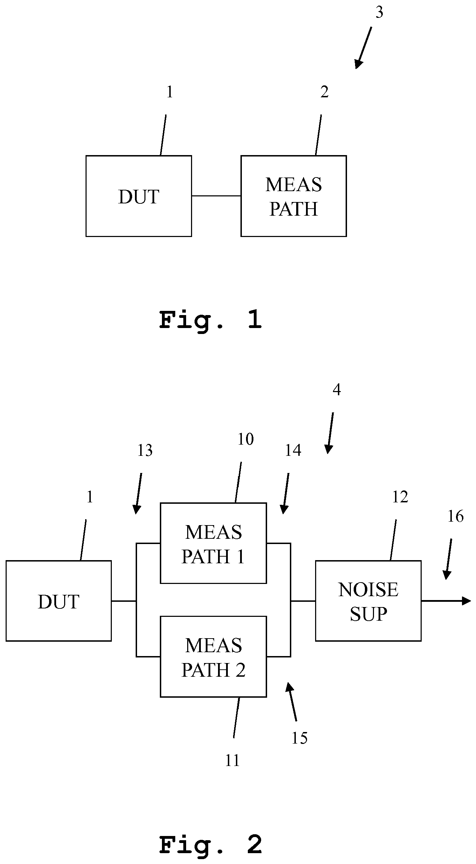

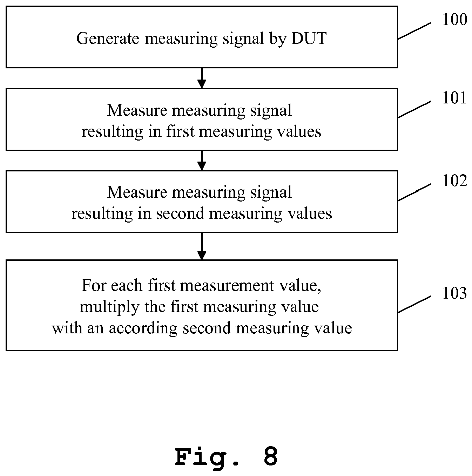

First we demonstrate the function of a state of the art measuring device and its drawbacks along Fig. 1. With regard to Fig. 2 - 7, different embodiments of the inventive measuring device are shown and described in detail. Finally, with regard to Fig. 8, an embodiment of the inventive measuring method is described in detail. Similar entities and reference numbers in different figures have been partially omitted.

In Fig. 1, a first exemplary measuring device 3 is shown. It comprises only a single measuring path 2, which is connected to a device under test 1. The measuring device records samples Y, which result from actual emissions $Y_{DUT}$ by the device under test, noise generated by the channel $Y_{channel,}$ and noise generated by the test equipment $Y_{TE}$, according to the following formula:

$$Y = Y_{\mathrm{DUT}} + Y_{\mathrm{channel}} + Y_{\mathrm{TE}} = Y_{\mathrm{DUT}} + Y_{\mathrm{ch,TE}}$$

It can clearly be seen that especially for low power levels of the signal emitted by the device under test 1, the noise generated by the channel and the test equipment can prevent an accurate measurement.

Even when normalizing over time according to the following formula:

$$\frac{1}{N} \sum_{k=1}^{N} \left| Y_1^{(k)} \right|^2$$

one cannot alleviate this issue, since the noise generated by the channel and the test equipment cannot be removed.

In Fig. 2, a first embodiment of the inventive measuring device 4 is shown. The inventive measuring device 4 comprises a first measuring path 10 and a second measuring path 11, which are both connected to a noise suppressor 12. A device under test 1 generates a measuring signal 13 and supplies it to the first measuring path 10 and the second measuring path 11. The measuring paths 10, 11 each measure the measuring signal 13 independently and generate first measuring values 14 and second measuring values 15. These are handed on to the noise suppressor 12, which generates a performance value signal 16 therefrom.

Especially, the noise suppressor 16 multiplies each of the first measuring values 14 with the according second measuring value 15 and sums up these products before normalizing the sum with the number of measuring signals and a base power level P. The first and according second measuring values belong to the same point in time. After calculating a square route, the resulting performance value 16 has been determined. This can be seen in the following formula:

$$X_{meas} = \sqrt{\frac{1}{NP_0} \sum_{K=1}^{N} Y_1^{(k)} \cdot \left(Y_2^{(k)}\right)^*} = X_{DUT}$$

wherein $Y_1^{(k)}$ is the $k^{th}$ sample of the first measuring value, $Y_2^{(k)}$ is the $k^{th}$ sample of the second measuring value, wherein k is the number of the presently processed sample, $P_0$ is the base power level, and N is the total number of processed samples. ()* denotes the complex conjugate of the value inside the brackets.

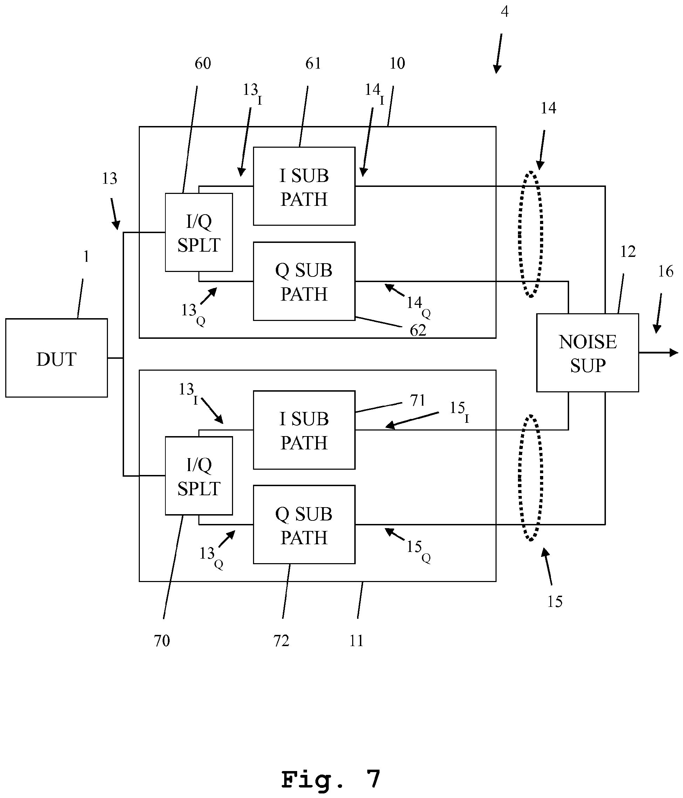

It is important to note that the formula is defined for values of $Y_1$ and $Y_2$, which do not comprise an imaginary part. Formulas, which are also defined for values of $Y_1$ and $Y_2$, which comprise an imaginary part are defined with regard to Fig. 7.

The above-shown formula is applicable to many different cases. For example, in band emissions or an error vector magnitude can be determined by this method.

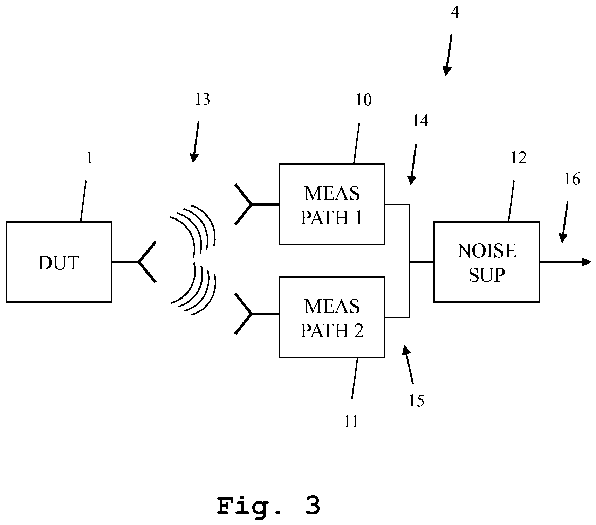

In the embodiment shown in Fig. 2, the device under test 1 is connected to the measuring paths 10, 11 by a wire-bound connection. In this case, the measuring device comprises a connector for an according cable. In Fig. 3, an alternative solution using an over the air measurement is shown. Here, the device under test 1 comprises an antenna while also each measuring path 10, 11 comprises an antenna for receiving the measuring signal 13.

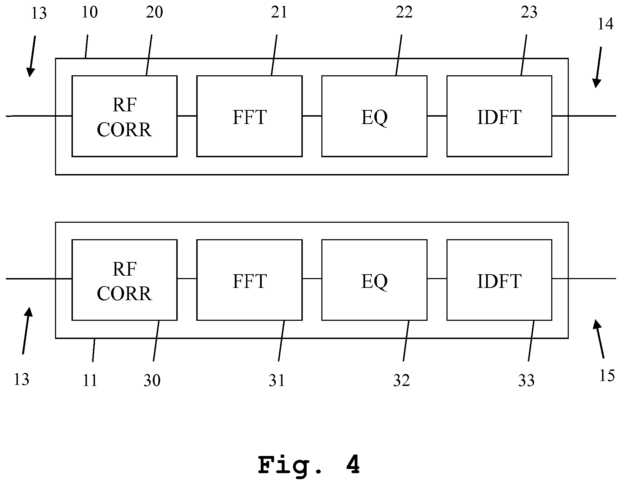

In Fig. 4, the detailed construction of the measuring paths 10, 11 is shown. In the exemplary embodiment shown here, each measuring path 10, 11 comprises a radio frequency corrector 20, which is connected to the device under test and supplied with the measuring signal 13. The radio frequency correctors 20, 30 determine and/or correct a carrier frequency error and/or a carrier frequency leakage.

Moreover, the measuring paths 10, 11 each comprise a fast Fourier transformer 21, 31, which is connected to the respective radio frequency corrector 20, 30 and transforms the signal into the frequency domain. Furthermore, the measuring paths 10, 11 comprise an equalizer 22, 32, connected to the fast Fourier transformers 21, 31. The equalizers perform a power level equalization of the signals on the two measuring paths 10, 11.

Finally, the measuring paths 10, 11 here comprise an inverse discrete Fourier transformer 23, 33, which transform the equalized signal back into the time domain. The output signals of the inverse discrete Fourier transformers 23, 33 form the first measuring values 14 and the second measuring values 15, respectively.

It is important to note that not all of these components are necessary. They can be individually used or not used as part of the measuring paths 10, 11.

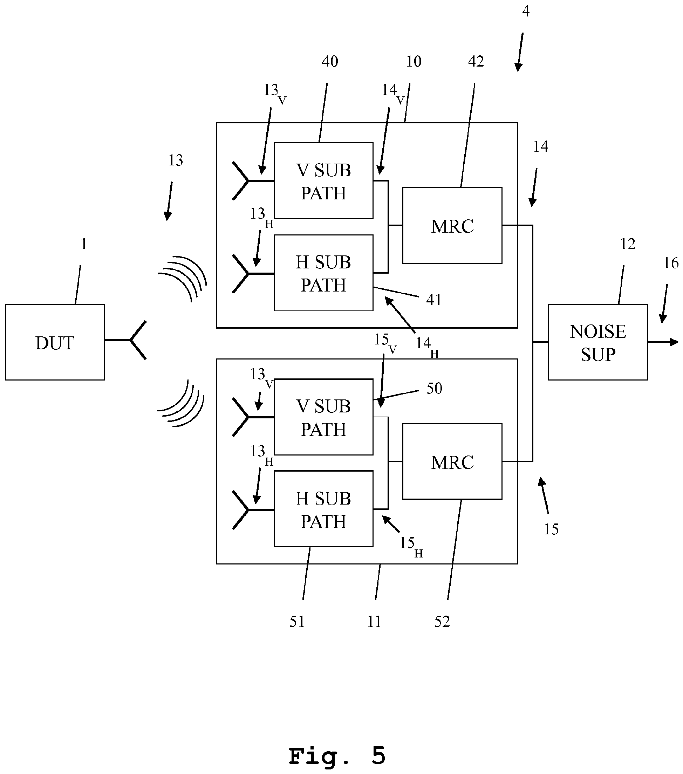

In Fig. 5, a further embodiment of the measuring device 4 is shown. Here, polarization is used to increase the measuring accuracy. Especially, each measuring path 10, 11 comprises a vertical sub path 40, 50 and a horizontal sub path 41, 51. The vertical sub paths 40, 50 each comprise a vertically polarized antenna and therefore receive a vertically polarized component of the measuring signal 13v. The horizontal sub paths 41, 51 each comprise a horizontally polarized antenna, and therefore receive a horizontally polarized component of the measuring signal $13_H$. Each of the sub paths 40, 41, 50, 51 are constructed such as any of the measuring paths 10, 11 as shown in Fig. 2 - Fig. 4. Resulting measuring values 14v of the vertical sub path 40 and resulting measuring values $14_h$ of the horizontal sub path 41 are provided to a maximum ratio combiner 42, which combines them to the first measuring values 14.

Resulting measuring values 15v of the measuring sub path 50 and resulting measuring values $15_H$ of the horizontal sub path 51 are handed on to a further maximum ratio combiner 52 and combined to the second measuring values 15.

Instead of using separate sub paths within the first measuring path the second measuring path, alternatively only a single hardware set up can be used successively. In this case, in a first step, the first measuring path and the second measuring path both measure horizontally polarized components of the measuring signal. In a second step both measuring paths measure vertically polarized components of the measuring signal. Finally, by use of only a single maximum ratio combiner, the according horizontally polarized measuring values and vertically polarized measuring values are combined, before being provided to the noise suppressor 12 as first measuring signal 14 and second measuring signal 15.

Also, instead of handling both the horizontally polarized components and the vertically polarized components of the measuring signal in both measuring paths, it is possible to handle only one polarization direction in each measuring path. The first measuring path 10 then would comprise two sub paths, which both handle for example the horizontal polarization, while the second measuring path 11 would then comprise two sub paths, which both handle the vertical polarization.

Also, it is possible to have sub paths, as shown in Fig. 5, only in one of the measuring paths.

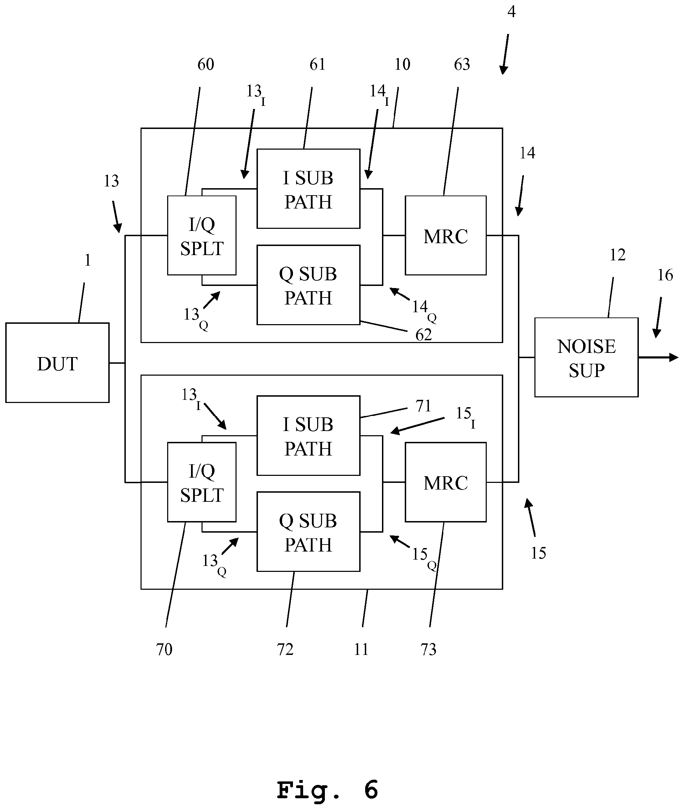

In Fig. 6, an embodiment of the measuring device 4 increasing accuracy by differentiating between an inphase component and a quadrature component is shown. The measuring paths 10, 11 here each comprise an inphase sub path 61, 71 and a quadrature sub path 62, 72. Moreover, each of the measuring paths 10, 11 comprise a I/Q splitter 60, 70, which generate an inphase component measuring signal $13_I$ and a quadrature component measuring signal $13_Q$. Alternatively, only a single I/Q splitter could be provided between the device under test 1 and the measuring paths 10, 11. The I/Q splitters 60, 70 can be implemented a I/Q mixers, in practice.

Each of the inphase sub paths 61, 71 and quadrature sub paths 62, 72 are constructed as the measuring paths 10, 11 of Fig. 1 - Fig. 4.

Therefore, the device under test 1 provides a measuring signal 13 to the I/Q splitters 60, 70 which generate an inphase component signal $13_I$ and a quadrature component measuring signal $13_Q$ therefrom. The inphase component measuring signals $13_I$ are provided to the inphase sub paths 61, 71 which perform measurement thereupon and generate inphase measuring values $14_I$, $15_I$. The quadrature component measuring signals $13_Q$ are provided to the quadrature sub paths 62, 72, which perform measurements thereupon and provide quadrature measuring values $14_Q$, $15_Q$. Within each of the measuring paths 10, 11, the inphase measuring values $14_I$, $15_I$ and the quadrature measuring values $14_Q$, $15Q$ are combined by a maximum ratio combiner 63, 73, resulting in the first measuring values 14 and the second measuring values 15, which again are handed on to the noise suppressor 12.

Fig. 7 shows an alternative embodiment to the embodiment of Fig. 6, without any maximum ratio combiners. Here, the inphase component signal $14_I$, and the quadrature component signal $14_Q$ together form a complex valued first measuring signal 14. Also, the inphase component signal $15_I$, and the quadrature component signal $15_Q$ together form a complex valued second measuring signal 15. The complex valued first measuring signal 14 and the complex valued second measuring signal 15 are directly fed into the noise suppressor, which is then setup for directly calculating the performance value signal 16 therefrom. This is done according to the following formula:

$$X_{meas} = \sqrt{\left| \frac{1}{NP_0} \sum_{K=1}^{N} Y_1^{(k)} \cdot \left( Y_2^{(k)} \right)^* \right|} = X_{DUT}$$

Here, the absolute value is calculated before the square root is drawn. Therefore, the formula is also defined for values of $Y_1$ and $Y_2$, which comprise an imaginary part and therefore may lead to a negative value under the square root.

Alternatively, the following formula may be used:

$$X_{meas} = \sqrt{\Re\left( \frac{1}{NP_0} \sum_{K=1}^{N} Y_1^{(k)} \cdot \left( Y_2^{(k)} \right)^* \right)} = X_{DUT}$$

Here, the real part of the term under the square root is calculated before the square root is drawn.

In the embodiments of Fig. 5 - 7, maximum ration combiners are used for combining the signals of sub paths. These maximum ratio combiners though do not have to be in the signal path all the time. This can be achieved by a switchable bypass. This is for example useful, if measuring signals are handled, which comprise only signals of a single polarization direction or signals which do not comprise an inphase component and an quadrature component. In this case, the embodiments of Fig. 5 - 7 work like the embodiment of Fig. 2 and Fig. 3. In these cases, the maximum ratio combiners are bypassed.

Finally, in Fig. 8 an embodiment of the inventive measuring method is shown in a flow diagram. In a first step 100, a measuring signal is generated by a device under test. In a second step 101, the measuring signal is measured by a first measuring path, resulting in first measuring values. In a third step 102, the measuring signals measured by a second measuring path, resulting in second measuring values. The second and third step 101, 102 are in particular performed simultaneously. In a final forth step 103, for each first measurement value, the first measuring value is multiplied with an according second measuring value. This allows for effectively removing the channel noise and measuring equipment noise.

The invention is not limited to the examples and especially not to the specific types of performance value signals shown above. The scope of the invention is defined by the appended claims.

**Claims**

1. Measuring device for transmitter performance measuring, comprising

   - a first measuring path, adapted to receive a measuring signal (13) from a device under test (1), and determine first measuring values (14) from the measuring signal (13),
   - a second measuring path (11), adapted to receive the measuring signal (13), and determine second measuring values (15) from the measuring signal (13), and
   - a noise suppressor (12), connected to an output of the first measuring path (10) and to an output of the second measuring path (11), which is adapted to
   - receive the first measuring values (14) and the second measuring values (15), and

- suppress noise, by, for each first measuring value (14), multiplying the first measuring value (14) with an according second measuring value (15) of the same point in time, generating a plurality of measuring value products, wherein the first measuring path and the second measuring path are identical.

2. Measuring device according to claim 1, wherein the noise suppressor (12) is adapted to determine a performance value signal (16) of the device under test (1) based upon the plurality of measuring value products, and wherein the performance signal (16) is advantageously an error vector magnitude or an inband emission.

3. Measuring device according to claim 1 or 2, wherein the noise suppressor (12) is adapted to

   - sum up the plurality of measuring value products,
   - normalize the summed up plurality of measuring value products by a number of measuring value products of the plurality of measuring value products and/or a base power level, generating a normalized sum of products, and
   - determine the performance value signal (16) based upon the normalized sum of products.

4. Measuring device according to claim 3, wherein the first measuring path (10) comprises a first antenna or a first connector for receiving the measuring signal (13), and wherein the second measuring path (11) comprises a second antenna or a second connector for receiving the measuring signal (13).

5. Measuring device according to any of the claims 1 to 3, wherein the measuring device (4) comprises a third antenna or a third connector for receiving the measuring signal (13), and wherein the measuring device comprises a splitter, adapted to split the received measuring signal (13) between the first measuring path (10) and the second measuring path (11) .

6. Measuring device according to any of the claims 1 to 5, wherein the first measuring path (10) and the second measuring path (11) each comprise a radio frequency corrector (20, 30), adapted to determine and/or correct a carrier frequency error and/or a carrier frequency leakage.

7. Measuring device according to any of the claims 1 to 6, wherein the first measuring path (10) and the second measuring path (11) each comprise a fast Fourier transformer (21, 31), adapted to transform the measuring signal (13) or a signal derived from the measuring signal (13) into the frequency domain.

8. Measuring device according to claim 7, wherein the first measuring path (10) and the second measuring path (11) each comprise an inverse discrete Fourier transformer (23, 33), adapted to transform a frequency domain signal, derived from the measuring signal (13) into the time domain.

9. Measuring device according to any of the claims 1 to 8, wherein the first measuring path (10) and/or the second measuring path (11) comprise an equalizer (22, 32), adapted to perform a signal level equalization of the first measuring path (10) and the second measuring path (11) .

10. Measuring device according to any of the claims 1 to 9, wherein the measuring signal (13) comprises vertically polarized components ($13_V$) and horizontally polarized components ($13_H$).

11. Measuring device according to claim 10, wherein the first measuring path (10) comprises a vertical sub path (40), adapted to receive the vertically polarized components ($13_V$) of the measuring signal (13), and generate first vertical sub measuring values ($14_V$) therefrom, wherein the first measuring path (10) comprises a horizontal sub path (41), adapted to receive the horizontally polarized components ($13_H$) of the measuring signal (13), and generate first horizontal sub measuring values ($14_H$) therefrom, wherein the second measuring path (11) comprises a vertical sub path (50), adapted to receive the vertically polarized components ($13_V$) of the measuring signal (13), and generate second vertical sub measuring values ($15_V$) therefrom, wherein the second measuring path (11) comprises a horizontal sub path (51), adapted to receive the horizontally polarized components ($13_H$) of the measuring signal (13), and generate second horizontal sub measuring values ($15_H$) therefrom, wherein the first measuring path (10) comprises a first maximum ratio combiner (42), adapted to combine the first vertical sub measuring values ($14_V$) and the first horizontal sub measuring values ($14_H$), resulting in the first measuring values (14), and wherein the second measuring path (11) comprises a second maximum ratio combiner (52), adapted to combine the second vertical sub measuring values ($15_V$) and the second horizontal sub measuring values ($15_H$), resulting in the second measuring values (15).

12. Measuring device according to claim 10,
wherein the first measuring path (10) is adapted to receive the vertically polarized components of the measuring signal (13), and generate first vertical sub measuring values therefrom, in a first step,
wherein the second measuring path (11) is adapted to receive the vertically polarized components of the measuring signal (13), and generate second vertical sub measuring values therefrom, in the first step,
wherein the first measuring path (10) is adapted to receive the horizontally polarized components of the measuring signal (13), and generate first horizontal sub measuring values therefrom, in a second step, and
wherein the second measuring path (11) is adapted to receive the horizontally polarized components of the measuring signal (13), and generate second horizontal sub measuring values therefrom, in the second step, and wherein the measuring device comprises a maximum ratio combiner, adapted to

- combine the first horizontal measuring values with the first vertical sub measuring values, and generate the first measuring values (14) therefrom, and
- combine the second horizontal sub measuring values with the second vertical sub measuring values, and generate the second measuring values (15) therefrom.

13. Measuring device according to any of the claims 1 to 12,
wherein the measuring device comprises a further fast Fourrier transformer, adapted to transform the performance signal into the frequency domain.

14. Measuring device according to any of the claims 1 to 13,
wherein the first measuring path (10) comprises a first inphase sub path (61), adapted to receive an inphase component ($13_I$) of the measuring signal (13), resulting in first inphase measuring values ($14_I$),
wherein the first measuring path (10) comprises a first quadrature sub path (62), adapted to receive a quadrature component ($13_Q$) of the measuring signal (13), resulting in first quadrature measuring values ($14_Q$),
wherein the second measuring path (11) comprises a second inphase sub path (71), adapted to receive the inphase component ($13_I$) of the measuring signal (13), resulting in second inphase measuring values ($15_I$),
wherein the second measuring path (11) comprises a second quadrature sub path (72), adapted to receive the quadrature component ($13_Q$) of the measuring signal (13), resulting in second quadrature measuring values ($15_Q$), and wherein the measuring device (4) comprises a first further maximum ratio combiner (63), adapted to combine the first inphase measuring values ($14_I$) with the first quadrature measuring values ($14_Q$), and generate the first measuring values (14) therefrom, and
wherein the measuring device (4) comprises a second further maximum ratio combiner (73), adapted to combine the second inphase measuring values ($15_I$) with the second quadrature measuring values ($15_Q$), and generate the second measuring values (15) therefrom.

15. Measuring method for transmitter performance measuring by using the measuring device of any of claims 1 to 14, the method comprising:

- receiving (101) a measuring signal (13) from a device under test (1), by a first measuring path (10), and determining first measuring values (14) from the measuring signal (13),
- receiving (102) the measuring signal (13), by a second measuring path (11), and determining second measuring values (15) from the measuring signal (13),
- receiving the first measuring values (14) and the second measuring values (15),
- for each first measuring value, multiplying (103) the first measuring value with an according second measuring value of the same point in time, generating a plurality of measuring value products,

wherein the first measuring path and the second measuring path are identical.

**Patentansprüche**

1. Messvorrichtung zur Senderleistungsmessung, das Folgendes umfasst

- einen ersten Messpfad, der angepasst ist, ein Messsignal (13) von einer zu testenden Vorrichtung (1) zu empfangen und anhand des Messsignals (13) erste Messwerte (14) zu bestimmen,
- einen zweiten Messpfad (11), der angepasst ist, das Messsignal (13) zu empfangen und anhand des Messsignals (13) zweite Messwerte (15) zu bestimmen, und
- einen Rauschunterdrücker (12), der mit einem Ausgang des ersten Messpfads (10) und mit einem Ausgang des zweiten Messpfads (11) verbunden und zu Folgendem angepasst ist
- Empfangen der ersten Messwerte (14) und der zweiten Messwerte (15), und
- Unterdrücken von Rauschen durch Multiplizieren des ersten Messwerts (14) mit einem entsprechenden zweiten Messwert (15) desselben Zeitpunkts, dadurch Erzeugen einer Vielzahl von Messwertprodukten für jeden ersten Messwert (14), wobei der erste Messpfad und der zweite Messpfad identisch sind.

2. Messvorrichtung nach Anspruch 1,
wobei der Rauschunterdrücker (12) angepasst ist, auf Basis der Vielzahl von Messwertprodukten ein Leistungswertsignal (16) der zu testenden Vorrichtung (1) zu bestimmen, und
wobei das Leistungssignal (16) vorteilhafterweise eine Fehlervektorgröße oder eine Inbandemission ist.

3. Messvorrichtung nach Anspruch 1 oder 2,
wobei der Rauschunterdrücker (12) zu Folgendem angepasst ist

- Summieren der Vielzahl von Messwertprodukten,
- Normalisieren der summierten Vielzahl von Messwertprodukten durch eine Anzahl von Messwertprodukten der Vielzahl von Messwertprodukten und/oder ein Grundleistungsniveau, dadurch Erzeugen einer normalisierten Summe von Produkten, und
- Bestimmen des Leistungswertsignals (16) auf Basis der normalisierten Summe von Produkten.

4. Messvorrichtung nach Anspruch 3,
wobei der erste Messpfad (10) eine erste Antenne oder einen ersten Verbinder zum Empfangen des Messsignals (13) umfasst, und
wobei der zweite Messpfad (11) eine zweite Antenne oder einen zweiten Verbinder zum Empfangen des Messsignals (13) umfasst.

5. Messvorrichtung nach einem der Ansprüche 1 bis 3,
wobei die Messvorrichtung (4) eine dritte Antenne oder einen dritten Verbinder zum Empfangen des Messsignals (13) umfasst, und
wobei die Messvorrichtung einen Splitter umfasst, der angepasst ist, das empfangene Messsignal (13) zwischen dem ersten Messpfad (10) und dem zweiten Messpfad (11) zu teilen.

6. Messvorrichtung nach einem der Ansprüche 1 bis 5,
wobei der erste Messpfad (10) und der zweite Messpfad (11) jeweils einen Funkfrequenzkorrektor (20, 30) umfassen, der angepasst ist, einen Trägerfrequenzfehler und/oder ein Trägerfrequenzleck zu bestimmen und/oder zu korrigieren.

7. Messvorrichtung nach einem der Ansprüche 1 bis 6,
wobei der erste Messpfad (10) und der zweite Messpfad (11) jeweils einen schnellen Fouriertransformator (21, 31) umfassen, der angepasst ist, das Messsignal (13) oder ein vom Messsignal (13) abgeleitetes Signal in die Frequenzdomäne umzuwandeln.

8. Messvorrichtung nach Anspruch 7,
wobei der erste Messpfad (10) und der zweite Messpfad (11) jeweils einen inversen diskreten Fouriertransformator (23, 33) umfassen, der angepasst ist, ein Frequenzdomänensignal, das vom Messsignal (13) abgeleitet ist, in die Zeitdomäne umzuwandeln.

9. Messvorrichtung nach einem der Ansprüche 1 bis 8,
wobei der erste Messpfad (10) und/oder der zweite Messpfad (11) einen Entzerrer (22, 32) umfassen, der angepasst ist, eine Signalpegelentzerrung des ersten Messpfads (10) und des zweiten Messpfads (11) durchzuführen.

10. Messvorrichtung nach einem der Ansprüche 1 bis 9,
wobei das Messsignal (13) vertikal polarisierte Komponenten (13$_V$) und horizontal polarisierte Komponenten (13$_H$) umfasst.

11. Messvorrichtung nach Anspruch 10,
wobei der erste Messpfad (10) einen vertikalen Unterpfad (40) umfasst, der angepasst ist, die vertikal polarisierten Komponenten (13$_V$) des Messsignals (13) zu empfangen und daraus erste vertikale Untermesswerte (14$_V$) zu erzeugen,
wobei der erste Messpfad (10) einen horizontalen Unterpfad (41) umfasst, der angepasst ist, die horizontal polarisierten Komponenten (13$_H$) des Messsignals (13) zu empfangen und daraus erste horizontale Untermesswerte (14$_H$) zu erzeugen,
wobei der zweite Messpfad (11) einen vertikalen Unterpfad (50) umfasst, der angepasst ist, die vertikal polarisierten Komponenten (13$_V$) des Messsignals (13) zu empfangen und daraus zweite vertikale Untermesswerte (15$_V$) zu erzeugen,
wobei der zweite Messpfad (11) einen horizontalen Unterpfad (51) umfasst, der angepasst ist, die horizontal polarisierten Komponenten (13$_H$) des Messsignals (13) zu empfangen und daraus zweite horizontale Untermesswerte (15$_H$) zu erzeugen,
wobei der erste Messpfad (10) einen ersten Maximumverhältniskombinierer (42) umfasst, der angepasst ist, die ersten vertikalen Untermesswerte (14$_V$) und die ersten horizontalen Untermesswerte (14$_H$) zu kombinieren, woraus die ersten Messwerte (14) resultieren, und
wobei der zweite Messpfad (11) einen zweiten Maximumverhältniskombinierer (52) umfasst, der angepasst ist, die zweiten vertikalen Untermesswerte (15$_V$) und die zweiten horizontalen Untermesswerte (15$_H$) zu kombinieren, woraus die zweiten Messwerte (15) resultieren.

12. Messvorrichtung nach Anspruch 10,

wobei der erste Messpfad (10) angepasst ist, in einem ersten Schritt die vertikal polarisierten Komponenten des Messsignals (13) zu empfangen und daraus erste vertikale Untermesswerte zu erzeugen,

wobei der zweite Messpfad (11) angepasst ist, im ersten Schritt die vertikal polarisierten Komponenten des Messsignals (13) zu empfangen und daraus zweite vertikale Untermesswerte zu erzeugen,

wobei der erste Messpfad (10) angepasst ist, in einem zweiten Schritt die horizontal polarisierten Komponenten des Messsignals (13) zu empfangen und daraus erste horizontale Untermesswerte zu erzeugen, und

wobei der zweite Messpfad (11) angepasst ist, im zweiten Schritt die horizontal polarisierten Komponenten des Messsignals (13) zu empfangen und daraus zweite horizontale Untermesswerte zu erzeugen, und

wobei die Messvorrichtung einen Maximumverhältniskombinierer umfasst, der zu Folgendem angepasst ist

- Kombinieren der ersten horizontalen Messwerte mit den ersten vertikalen Untermesswerten und Erzeugen der ersten Messwerte (14) daraus, und
- Kombinieren der zweiten horizontalen Untermesswerte mit den zweiten vertikalen Untermesswerten und Erzeugen der zweiten Messwerte (15) daraus.

13. Messvorrichtung nach einem der Ansprüche 1 bis 12,
wobei die Messvorrichtung einen weiteren schnellen Fouriertransformator umfasst, der angepasst ist, das Leistungssignal in die Frequenzdomäne umzuwandeln.

14. Messvorrichtung nach einem der Ansprüche 1 bis 13,
wobei der erste Messpfad (10) einen ersten Inphasenunterpfad (61) umfasst, der angepasst ist, eine Inphasenkomponente $(13_I)$ des Messsignals (13) zu empfangen, was in ersten Inphasenmesswerten $(14_I)$ resultiert,
wobei der erste Messpfad (10) einen ersten Quadraturunterpfad (62) umfasst, der angepasst ist, eine Quadraturkomponente $(13_Q)$ des Messsignals (13) zu empfangen, was in ersten Quadraturmesswerten $(14_Q)$ resultiert,
wobei der zweite Messpfad (11) einen zweiten Inphasenunterpfad (71) umfasst, der angepasst ist, die Inphasenkomponente $(13_I)$ des Messsignals (13) zu empfangen, was in zweiten Inphasenmesswerten $(15_I)$ resultiert,
wobei der zweite Messpfad (11) einen zweiten Quadraturunterpfad (72) umfasst, der angepasst ist, die Quadraturkomponente $(13_Q)$ des Messsignals (13) zu empfangen, was in zweiten Quadraturmesswerten $(15_Q)$ resultiert, und

wobei die Messvorrichtung (4) einen ersten weiteren Maximumverhältniskombinierer (63) umfasst, der angepasst ist, die ersten Inphasenmesswerte $(14_I)$ mit den ersten Quadraturmesswerten $(14_Q)$ zu kombinieren und daraus die ersten Messwerte (14) zu erzeugen, und

wobei die Messvorrichtung (4) einen zweiten weiteren Maximumverhältniskombinierer (73) umfasst, der angepasst ist, die zweiten Inphasenmesswerte $(15_I)$ mit den zweiten Quadraturmesswerten $(15_Q)$ zu kombinieren und daraus die zweiten Messwerte (15) zu erzeugen.

15. Messverfahren zur Senderleistungsmessung unter Verwendung der Messvorrichtung von einem der Ansprüche 1 bis 14, wobei das Verfahren Folgendes umfasst:

- Empfangen (101) eines Messsignals (13) über einen ersten Messpfad (10) von einer zu testenden Vorrichtung (1) und Bestimmen von ersten Messwerten (14) aus dem Messsignal (13),
- Empfangen (102) des Messsignals (13) über einen zweiten Messpfad (11) und Bestimmen von zweiten Messwerten (15) aus dem Messsignal (13),
- Empfangen der ersten Messwerte (14) und der zweiten Messwerte (15),
- Multiplizieren (103) des ersten Messwerts mit einem entsprechenden zweiten Messwert desselben Zeitpunkts, dadurch Erzeugen einer Vielzahl von Messwertprodukten für jeden ersten Messwert,

wobei der erste Messpfad und der zweite Messpfad identisch sind.

**Revendications**

1. Dispositif de mesure pour la mesure de performances d'émetteur, comprenant

- une première voie de mesure, conçue pour recevoir un signal de mesure (13) à partir d'un dispositif en cours de test (1), et déterminer des premières valeurs de mesure (14) à partir du signal de mesure (13),
- une seconde voie de mesure (11), conçue pour recevoir le signal de mesure (13), et déterminer des secondes valeurs de mesure (15) à partir du signal de mesure (13), et
- un suppresseur de bruit (12), connecté à une sortie de la première voie de mesure (10) et à une sortie de la seconde voie de mesure (11), qui est conçu pour

- recevoir les premières valeurs de mesure (14) et les secondes valeurs de mesure (15), et
- supprimer un bruit, par, pour chaque première valeur de mesure (14), la multiplication de la première valeur de mesure (14) avec une seconde valeur de mesure (15) associée du même point dans le temps, ce qui génère une pluralité de produits de valeurs de mesure,

dans lequel la première voie de mesure et la seconde voie de mesure sont identiques.

2. Dispositif de mesure selon la revendication 1, dans lequel le suppresseur de bruit (12) est conçu pour déterminer un signal de valeur de performances (16) du dispositif en cours de test (1) sur la base de la pluralité de produits de valeurs de mesure, et dans lequel le signal de performances (16) est avantageusement une amplitude de vecteur d'erreur ou une émission intrabande.

3. Dispositif de mesure selon la revendication 1 ou 2, dans lequel le suppresseur de bruit (12) est conçu pour

- additionner la pluralité de produits de valeurs de mesure,
- normaliser la pluralité additionnée de produits de valeurs de mesure par un certain nombre de produits de valeurs de mesure de la pluralité de produits de valeurs de mesure et/ou un niveau de puissance de base, ce qui génère une somme normalisée de produits, et
- déterminer le signal de valeur de performances (16) sur la base de la somme de produits normalisée.

4. Dispositif de mesure selon la revendication 3, dans lequel la première voie de mesure (10) comprend une première antenne ou un premier connecteur pour la réception du signal de mesure (13), et dans lequel la seconde voie de mesure (11) comprend une deuxième antenne ou un deuxième connecteur pour la réception du signal de mesure (13).

5. Dispositif de mesure selon l'une quelconque des revendications 1 à 3, dans lequel le dispositif de mesure (4) comprend une troisième antenne ou un troisième connecteur pour la réception du signal de mesure (13), et dans lequel le dispositif de mesure comprend un diviseur, conçu pour diviser le signal de mesure (13) reçu entre la première voie de mesure (10) et la seconde voie de mesure (11).

6. Dispositif de mesure selon l'une quelconque des revendications 1 à 5, dans lequel la première voie de mesure (10) et la seconde voie de mesure (11) comprennent chacune un correcteur radiofréquence (20, 30), conçu pour déterminer et/ou corriger une erreur de fréquence porteuse et/ou une fuite de fréquence porteuse.

7. Dispositif de mesure selon l'une quelconque des revendications 1 à 6, dans lequel la première voie de mesure (10) et la seconde voie de mesure (11) comprennent chacune un dispositif à transformée de Fourier rapide (21, 31), conçu pour transformer le signal de mesure (13) ou un signal dérivé du signal de mesure (13) vers le domaine fréquentiel.

8. Dispositif de mesure selon la revendication 7, dans lequel la première voie de mesure (10) et la seconde voie de mesure (11) comprennent chacune un dispositif à transformée de Fourier discrète inverse (23, 33), conçu pour transformer un signal dans le domaine fréquentiel dérivé du signal de mesure (13) vers le domaine temporel.

9. Dispositif de mesure selon l'une quelconque des revendications 1 à 8, dans lequel la première voie de mesure (10) et/ou la seconde voie de mesure (11) comprennent un égaliseur (22, 32), conçu pour réaliser une égalisation de niveau de signal de la première voie de mesure (10) et de la seconde voie de mesure (11) .

10. Dispositif de mesure selon l'une quelconque des revendications 1 à 9, dans lequel le signal de mesure (13) comprend des composantes à polarisation verticale ($13_V$) et des composantes à polarisation horizontale ($13_H$).

11. Dispositif de mesure selon la revendication 10, dans lequel la première voie de mesure (10) comprend une sous-voie verticale (40), conçue pour recevoir les composantes à polarisation verticale ($13_V$) du signal de mesure (13), et générer des premières sous-valeurs de mesure verticales ($14_V$) à partir de celles-ci, dans lequel la première voie de mesure (10) comprend une sous-voie horizontale (41), conçue pour recevoir les composantes à polarisation horizontale ($13_H$) du signal de mesure (13), et générer des premières sous-valeurs de mesure horizontales ($14_H$) à partir de celles-ci, dans lequel la seconde voie de mesure (11) comprend une sous-voie verticale (50), conçue pour recevoir les composantes à polarisation verticale ($13_V$) du signal de mesure (13), et générer des secondes sous-valeurs de mesure verticales ($15_V$) à partir de celles-ci, dans lequel la seconde voie de mesure (11) comprend une sous-voie horizontale (51), conçue pour recevoir les composantes à polarisation horizontale

($13_H$) du signal de mesure (13), et générer des secondes sous-valeurs de mesure horizontales ($15_H$) à partir de celles-ci,

dans lequel la première voie de mesure (10) comprend un premier combinateur à rapport maximal (42), conçu pour combiner les premières sous-valeurs de mesure verticales ($14_V$) et les premières sous-valeurs de mesure horizontales ($14_H$), ce qui résulte en les premières valeurs de mesure (14), et

dans lequel la seconde voie de mesure (11) comprend un second combinateur à rapport maximal (52), conçu pour combiner les secondes sous-valeurs de mesure verticales ($15_V$) et les secondes sous-valeurs de mesure horizontales ($15_H$), ce qui résulte en les secondes valeurs de mesure (15).

**12.** Dispositif de mesure selon la revendication 10,

dans lequel la première voie de mesure (10) est conçue pour recevoir les composantes à polarisation verticale du signal de mesure (13), et générer des premières sous-valeurs de mesure verticales à partir de celles-ci, lors d'une première étape,

dans lequel la seconde voie de mesure (11) est conçue pour recevoir les composantes à polarisation verticale du signal de mesure (13), et générer des secondes sous-valeurs de mesure verticales à partir de celles-ci, lors de la première étape,

dans lequel la première voie de mesure (10) est conçue pour recevoir les composantes à polarisation horizontale du signal de mesure (13), et générer des premières sous-valeurs de mesure horizontales à partir de celles-ci, lors d'une seconde étape, et

dans lequel la seconde voie de mesure (11) est conçue pour recevoir les composantes à polarisation horizontale du signal de mesure (13), et générer des secondes sous-valeurs de mesure horizontales à partir de celles-ci, lors de la seconde étape, et

dans lequel le dispositif de mesure comprend un combinateur à rapport maximal, conçu pour

- combiner les premières valeurs de mesure horizontales avec les premières sous-valeurs de mesure verticales, et générer les premières valeurs de mesure (14) à partir de celles-ci, et
- combiner les secondes sous-valeurs de mesure horizontales avec les secondes sous-valeurs de mesure verticales, et générer les secondes valeurs de mesure (15) à partir de celles-ci.

**13.** Dispositif de mesure selon l'une quelconque des revendications 1 à 12,

dans lequel le dispositif de mesure comprend un dispositif à transformée de Fourier rapide supplémentaire, conçu pour transformer le signal de performances vers le domaine fréquentiel.

**14.** Dispositif de mesure selon l'une quelconque des revendications 1 à 13,

dans lequel la première voie de mesure (10) comprend une première sous-voie en phase (61), conçue pour recevoir une composante en phase ($13_I$) du signal de mesure (13), ce qui résulte en des premières valeurs de mesure en phase ($14_I$),

dans lequel la première voie de mesure (10) comprend une première sous-voie en quadrature (62), conçue pour recevoir une composante en quadrature ($13_Q$) du signal de mesure (13), ce qui résulte en des premières valeurs de mesure en quadrature ($14_Q$),

dans lequel la seconde voie de mesure (11) comprend une seconde sous-voie en phase (71), conçue pour recevoir la composante en phase ($13_I$) du signal de mesure (13), ce qui résulte en des secondes valeurs de mesure en phase ($15_I$),

dans lequel la seconde voie de mesure (11) comprend une seconde sous-voie en quadrature (72), conçue pour recevoir la composante en quadrature ($13_Q$) du signal de mesure (13), ce qui résulte en des secondes valeurs de mesure en quadrature ($15_Q$), et

dans lequel le dispositif de mesure (4) comprend un premier combinateur à rapport maximal (63) supplémentaire, conçu pour combiner les premières valeurs de mesure en phase ($14_I$) avec les premières valeurs de mesure en quadrature ($14_Q$), et générer les premières valeurs de mesure (14) à partir de celles-ci, et

dans lequel le dispositif de mesure (4) comprend un second combinateur à rapport maximal (73) supplémentaire, conçu pour combiner les secondes valeurs de mesure en phase ($15_I$) avec les secondes valeurs de mesure en quadrature ($15_Q$), et générer les secondes valeurs de mesure (15) à partir de celles-ci.

**15.** Procédé de mesure pour la mesure de performances d'émetteur en utilisant le dispositif de mesure selon l'une quelconque des revendications 1 à 14, le procédé comprenant :

- la réception (101) d'un signal de mesure (13) à partir d'un dispositif en cours de test (1), par une première voie de mesure (10), et la détermination de premières valeurs de mesure (14) à partir du signal de mesure (13),
- la réception (102) du signal de mesure (13), par une seconde voie de mesure (11), et la détermination de secondes valeurs de mesure (15) à partir du signal de mesure (13),
- la réception des premières valeurs de mesure (14) et des secondes valeurs de mesure (15),
- pour chaque première valeur de mesure, la multiplication (103) de la première valeur de mesure avec une seconde valeur de mesure associée du même point dans le temps, ce qui génère une pluralité de produits de valeurs de mesure, dans lequel la première voie de mesure et la seconde voie de mesure sont identiques.

**Fig. 1**

**Fig. 2**

Fig. 3

**Fig. 4**

**Fig. 5**

Fig. 6

Fig. 7

| Generate measuring signal by DUT | 100 |

| Measure measuring signal resulting in first measuring values | 101 |

| Measure measuring signal resulting in second measuring values | 102 |

| For each first measurement value, multiply the first measuring value with an according second measuring value | 103 |

Fig. 8

**EP 3 486 666 B1**

**REFERENCES CITED IN THE DESCRIPTION**

**Patent documents cited in the description**

- US 20070225927 A
- US 20150138995 A1
- US 20120217980 A1
- JP 2010141448 A